# EUROPEAN PATENT APPLICATION

(11) **EP 4 694 619 A1**
(43) Date of publication of application: **11.02.2026**
(21) Application number: 24223124.9
(22) Date of filing: 23.12.2024
(51) Int. Cl.: H10D 62/10, H10D 30/01, H10D 30/67, H10D 62/80

(54) **THIN-FILM TRANSISTOR HAVING AN AMORPHOUS CHANNEL WITH CRYSTALLINE QUANTUM DOTS, EXHIBITING A REDUCED LOW-FREQEUNCY NOISE.**

(30) Priority: 06.08.2024 KR 20240104839; 06.12.2024 KR 20240180171
(71) Applicant: POSTECH Research and Business Development Foundation, Pohang-si, Gyeongsangbuk-do 37673 (KR)
(72) Inventor: LEE, Byoung Hun, Pohang-si 37673 (KR); HWANG, Hyeon Jun, Pohang-si 37673 (KR); KIM, Seung Mo, Pohang-si 37673 (KR); LEE, Hae Won, Pohang-si 37673 (KR); JUN, Jae Hyeon, Pohang-si 37673 (KR)
(74) Representative: Marks & Clerk LLP

(57) **Abstract**

A transistor, in particular a semiconductor-oxide thin-film transistor, with improved low-frequency noise characteristics is disclosed. A phase complexing channel layer (130) having quantum dots (131) distributed within an amorphous matrix (132) is formed, where the material of the quantum dots (131) and of the amorphous matrix (132) is the same. A surface stabilization layer (140) is formed in contact with the phase complexing channel layer (130). The surface stabilization layer may have a superlattice structure and has a repeating structure of an inorganic insulating layer (141) and an organic shielding layer (142). The surface stabilization layer is formed laterally between a source electrode and a drain electrode. Since the quantum dots (131) of the phase complexing channel layer (130) are in a quantized state, carriers trapped in the quantum dots cannot be trapped at the interface with the underlying gate-dielectric .In this way the flicker noise is reduced, which is in particular beneficial for low-frequency operation.

## Description

### [Technical Field]

The present invention is related to device having channel layer in which nanoparticles are included, more particularly to transistor with improved low frequency noise characteristics and a device utilizing the same

### [Background Art]

Noise is referred to electrical signal that interferes with the operation of a device. The sources of noise are very diverse, and noise can be categorized into low-frequency noise and high-frequency noise depending on the frequency. In particular, low-frequency noise generally refers to noise generated at a frequency of 100 kHz or less, and low-frequency noise is not radiated or transmitted to the outside of the device from which it is generated, but is embedded in the ordinary signal inside the device, causing the device to malfunction. Therefore, low-frequency noise is referred to as device noise.

The noise described above is mainly generated in the field effect transistor (FET) structure of semiconductors and is categorized into thermal noise, flicker noise, and shot noise.

Thermal noise is caused by resistive elements in the channel of the device, and the generation of heat causes scattering of space charge and irregular motion of electrons in the device. It is the scattering and irregular motion that results in thermal noise, and this noise appears over a wide range of frequency bands.

Flicker noise is referred as 1/f noise and is characterized by being inversely proportion to the frequency f. In transistors such as FETs, carriers move in the channel, where they are trapped at the interface of the gate dielectric layer and detrapped again at random, unspecified times and states. The process of trapping and detrapping at the interface of the gate dielectric layer is what generates flicker noise. This is a variable that cannot be controlled externally and cannot be arbitrarily reduced by the user.

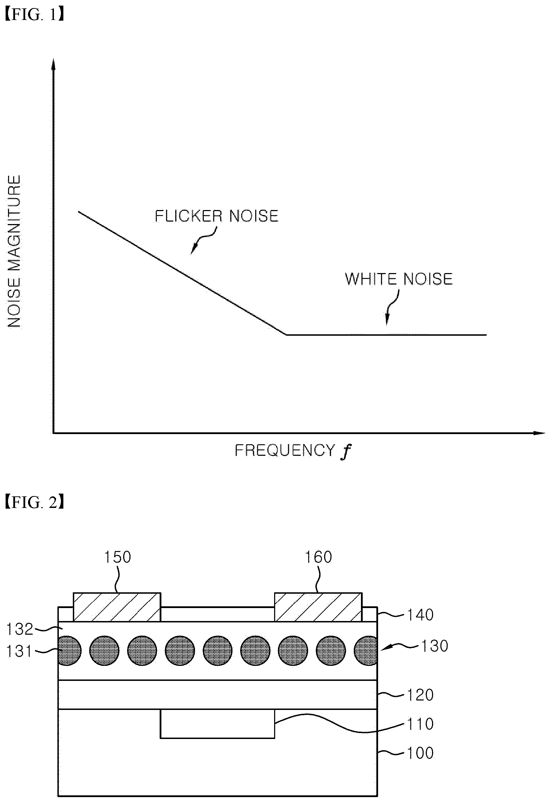

FIG. 1 is a graph illustrating the characteristics of flicker noise according to the prior art.

Referring to FIG. 1, flicker noise is characterized in that its magnitude is inversely proportional to its frequency. At high frequencies, little flicker noise is generated, and the noise of the device is dominated by thermal noise. The flicker noise is characterized by a dominant appearance in the low frequency range and dominates the noise in the low frequency region.

White noise is generated above the frequency at which flicker noise occurs and is generated when the gate-source voltage of a transistor approaches the threshold voltage and has a negligible effect on the behavior of the device.

As mentioned above, in the low frequency region, flicker noise has a significant impact on the behavior of the device and is embedded in the signals transmitted through the transistor, which has a significant impact on the behavior of the device. In addition, as the design rules of semiconductors shrink and the operating voltage of the transistor decreases, the size of the channel decreases, and the relative density of carriers trapped at the interface of the gate dielectric layer increases. This means that unless the concentration of carriers trapped or detrapped at the interface of the gate dielectric layer is dramatically reduced relative to the low amount of charge flowing through the channel, low frequency noise becomes an unavoidable problem.

In particular, there are many dangling bonds at the interface of the channel layer composed of single crystalline silicon and the amorphous gate dielectric layer, which act as trap sites for carriers. To solve this problem, the interfacial properties need to be improved, but improving the interfacial properties between single crystals and amorphous is practically impossible. In other words, the control of the interfacial properties between two types of layers with different materials and properties remains an unsolved problem.

### [Disclosure]

### [Technical Problem]

The present invention is directed to providing a low noise transistor with flicker noise eliminated.

### [Technical Solution]

One aspect of the present invention provides a low-noise transistor comprising a gate electrode formed on a substrate, a gate dielectric layer formed on the gate electrode, a phase complexing channel layer formed on the gate dielectric layer and having quantum dots formed within an amorphous matrix, a surface stabilization layer formed on the phase complexing channel layer and removing flicker noise, and a source electrode and a drain electrode formed on the composite channel layer.

The surface stabilization layer is formed in direct contact with the phase complexing channel layer in a space between the source electrode and the drain electrode.

Another aspect of the present invention provides a low-noise transistor comprising a phase complexing channel layer formed on a gate dielectric layer, in which quantum dots are formed as a single layer within an amorphous matrix, and a surface stabilization layer in contact with the phase complexing channel layer and having a superlattice structure of an inorganic insulating layer and an organic shielding layer.

The surface stabilization layer has a higher band gap than the phase complexing channel layer, the operation in the saturation region is performed even at Vgs having a value greater than Vds.

Still another aspect of the present invention provides a low-noise transistor comprising a source electrode grounded at a small signal level, a drain electrode opposite the source electrode, and a gate electrode to which an input voltage of a small-signal level is applied.

The low-noise transistor comprises a gate dielectric layer formed on the gate electrode, a phase complexing channel layer formed on the gate dielectric layer, and a surface stabilization layer formed on the phase complexing channel layer.

The source electrode and the drain electrode are formed opposite to each other while directly contacting the phase complexing channel layer, and even if gate voltage increases, drain current flowing through the drain electrode to source electrode maintains a constant level by state hybridization of carriers.

### [Advantageous Effects]

According to the present invention, carrier concentration in the phase complexing channel layer is limited to the saturation state, and the introduction of the surface stabilization layer essentially eliminates flicker noise. However, in the absence of the surface stabilizing layer, the carrier concentration increases with the application of the gate voltage, and Ids increases with the increased carrier concentration. Furthermore, the carriers trapped or detrapped at the interface of the gate dielectric film also increase due to the increased carrier concentration.

In the present invention, Ids remains constant as the gate voltage is increased in the common source configuration, and the transistor exhibits virtually no substantial output resistance, so that flicker noise is not appeared.

### [Description of Drawings]

FIG. 1 is a graph illustrating the characteristics of flicker noise according to the prior art.
FIG. 2 is a cross-sectional view illustrating a transistor with improved low frequency noise characteristics according to an embodiment of the present invention.
FIG. 3 is a schematic diagram illustrating a high-pressure atomic layer deposition method according to an embodiment of the present invention.
FIG. 4 is a cross-sectional view illustrating the phase complexing channel layer and surface stabilization layer of FIG. 2, in accordance with a preferred embodiment of the present invention.
FIG. 5 is an image of quantum dots in a composite channel layer formed according to Manufacturing Example 1 of the present invention.
FIG. 6 is a graph of the electrical characteristics of two samples measured according to measurement example of the present invention.
FIG. 7 is a graph of measuring noise according to measurement example of the present invention.

### [Modes of the Invention]

Hereinafter, embodiments of the present invention will be described in detail with reference to the accompanying drawings.

While the present invention is susceptible to various modifications and alternative forms, specific embodiments thereof are shown by way of example in the drawings and will herein be described in detail. However, it should be understood that there is no intent to limit the invention to the particular forms disclosed but rather the invention is to cover all modifications, equivalents, and alternatives falling within the spirit and scope of the invention defined by the appended claims.

When an element such as a layer, a region, and a substrate is referred to as being disposed "on" another element, it should be understood that the element may be directly formed on the other element or an intervening element may be interposed therebetween.

It should be understood that, although the terms "first," "second," etc. may be used herein to describe various elements, components, areas, layers, and/or regions, these elements, components, areas, layers, and/or regions are not limited by these terms.

### EMBODIMENT

FIG. 2 is a cross-sectional view illustrating a transistor with improved low frequency noise characteristics according to an embodiment of the present invention.

Referring to FIG. 2, the transistor of present embodiment has a substrate 100, a gate electrode 110, a gate dielectric layer 120, a phase complexing channel layer 130, a surface stabilization layer 140, a source electrode 150, and a drain electrode 160.

The phase complexing channel layer 130 has a monolayer of quantum dots 131, which are single crystal structure or polycrystal structure, distributed and spaced apart in an amorphous matrix 132. In particular, the quantum dot 131 has a size of 5 nm or less in diameter. The quantum dots 131 are formed along channels and have a mechanism for carrier transport between the quantum dots 131.

The amorphous matrix 132 can be interpreted as an unquantized continuous system, and the quantum dots 131, which are crystalline particles, can be interpreted as a quantized closed system, i.e., the amorphous matrix 132 is allowed to have a continuum of energy states, or it becomes a substantially open system with very narrow spacing of state energies. In addition, the quantum dots 131 have discrete energy states and constitute a closed system in which only certain energy states are allowed.

The phase complexing channel layer 130 is interpreted as a junction of a quantized closed system and a continuous open system, where the carriers of the quantized state are hybridized by the electric field applied between the source electrode 150 and the drain electrode 160, and by the electric field applied between source electrode 150 and the gate electrode 110. The hybridization of the present invention refers to the physical phenomenon whereby quantized carriers in the quantum dot 131 tunnel or are moved by an electric field through the amorphous matrix 132, which is amorphous phase. For hybridization to occur, the quantum dot 131 and the amorphous matrix 132 need to be of the same material. More specifically, at the interface of the crystalline structure of quantum dots 131 and the amorphous matrix 132, there may be exist an mesophase that transitions from crystalline to amorphous, which are the same material.

The phase complexing channel layer 130 may be formed as an n-type or p-type. If the phase complexing channel layer 130 is the n-type, the phase complexing channel layer 130 may include ZnO, MoS₂, or IGZO. In addition, the p-type phase complexing channel layer 130 may have SnO or Te. In other words, the phase complexing channel layer 130 is not limited to a material if it has a structure with crystalline quantum dots distributed within an amorphous matrix.

A surface stabilization layer 140 is formed on the phase complexing channel layer 130. The surface stabilization layer 140 contacts with the phase complexing channel layer 130, has a higher bandgap than the phase complexing channel layer 130, and contributes to the hybridization of quantized carriers.

The surface stabilization layer 140 consists of an organic shielding layer in which metals are bonded or doped to the organic material, and an insulating layer. In particular, the surface stabilization layer 140 completely covers the phase complexing channel layer 130 between the source electrode 150 and the drain electrode 160.

Further, the source electrode 150 and the drain electrode 160 are in direct contact with the composite channel layer 130. The source electrode 150 and the drain electrode 160 are disposed opposite each other, centered on the lower gate electrode 110. Carriers from the source electrode 150 are supplied into the phase complexing channel layer 130, and carriers flowing through the phase complexing channel layer 130 are discharged to the drain electrode 160.

The surface stabilization layer 140 has a higher bandgap than the amorphous matrix 132 or the quantum dots 131 of the phase complexing channel layer 130, and the high bandgap induces the quantum dots 131 of the phase complexing channel layer 130 to have a double quantum well structure, i.e., a first barrier layer of the amorphous matrix 132 surrounding the quantum dots 131 is formed, and the surface stabilization layer 140 forms a second barrier to enhance the state hybridization.

In addition, the source electrode 150 and the drain electrode 160 are directly contacted on the phase complexing channel layer 130. The direct contact of the source electrode 150 and the drain electrode 160 can induce a decrease in the operating voltage to activate the phase complexing channel layer 130.

When a gate-source voltage above a certain level is applied, carriers from the source electrode 150 can be supplied to the phase complexing channel layer 130. In other words, the action of supplying activation energy to the quantum dots 131 to turn on the phase complexing channel layer 130 is described as a threshold voltage, and gate-source voltage having a level above the threshold voltage is additionally required to continuously supply carriers to the phase complexing channel layer 130.

Carriers tunneling through the amorphous matrix 132 from the source electrode 150 are trapped in the quantum dots 131. The phase complexing channel layer 130 has an amorphous matrix 132 and quantum dots 131, and carriers are trapped in specific energy states within the quantum dots 131. Carriers trapped in the quantum dots 131 and having a specific energy state are transported through the amorphous matrix 132, which is a continuous system, to neighboring quantum dots 131. Here, it is highly unlikely that carriers trapped in the quantum dots 131 will be trapped at the interface of the gate dielectric layer 120 under the influence of the gate electrode 110.

This is due to the relatively large thickness of the amorphous matrix 132 distributed between the quantum dots 131 and the gate dielectric layer 120, i.e., the separation distance between the quantum dots 131 and the gate dielectric layer 120 is much larger than the separation distance between the quantum dots 131, so the probability of carriers tunneling through the amorphous matrix between the quantum dots 131 and the gate dielectric layer 120 is close to 0 %.

Furthermore, since a surface stabilizing layer 140 is disposed on the phase complexing channel layer 130, external influences are blocked by the surface stabilizing layer 140, and since the surface stabilizing layer 140 has a higher bandgap than the phase complexing channel layer 130, the probability of carriers being trapped on the surface of the phase complexing channel layer 130 is almost 0 %.

Thus, a mechanism is formed for carriers to move between the quantum dots 131 by tunneling through the amorphous matrix 132 or through a continuous system.

It will be appreciated that the substrate 100 in FIG. 2 can be any insulating material, and that any material whose properties do not change during the formation process of the various functional layers can be used. In particular, the substrate 100 need not be limited to flexible or non-flexible, and may be any insulating material capable of forming the gate electrode 110. For example, the substrate 100 may have a SiO₂ material.

The gate electrode 110 is formed on the substrate 100. The gate electrode 110 can be any conductive material, and can be a metal or doped polysilicon. Exemplary metal that can be used includes Au, Pt, Ag, Ni, Al, W, or Pd.

A gate dielectric layer 120 is formed on the gate electrode 110. The gate dielectric layer 120 is an insulating material, and preferably a high dielectric constant material is used. For example, Al₂O₃, HfO₂, or ZrO₂ may be used, but is not limited to, and SiO₂ may also be used.

On the gate dielectric layer 120, a phase complexing channel layer 130 is formed. The phase complexing channel layer 130 may be n-type doped, and may be p-type doped, that is, the phase complexing channel layer 130 may be an n-type semiconductor, and may be a p-type semiconductor. In order for the phase complexing channel layer 130 to be composed of an n-type semiconductor, the phase complexing channel layer 130 may have ZnO, IGZO, or MoS₂. Further, in order for the phase complexing channel layer 130 to be composed of a p-type semiconductor, the phase complexing channel layer 130 may have a Te or SnO material.

The phase complexing channel layer 130 has a plurality of quantum dots 131 formed in parallel in the amorphous matrix 132. Furthermore, the materials of the amorphous matrix 132 and the quantum dots 131 are mutually identical, and the phase complexing channel layer 130 is formed in a single process.

For the formation of the phase complexing channel layer 130, a high-pressure atomic layer deposition method is used. Conventional atomic layer deposition methods have a short precursor dosing time, and after precursor dosing, the partial pressure of the precursor in the chamber is only a few tens of mTorr. For the formation of the phase complexing channel layer 130 of the present invention, high pressure atomic layer deposition is used.

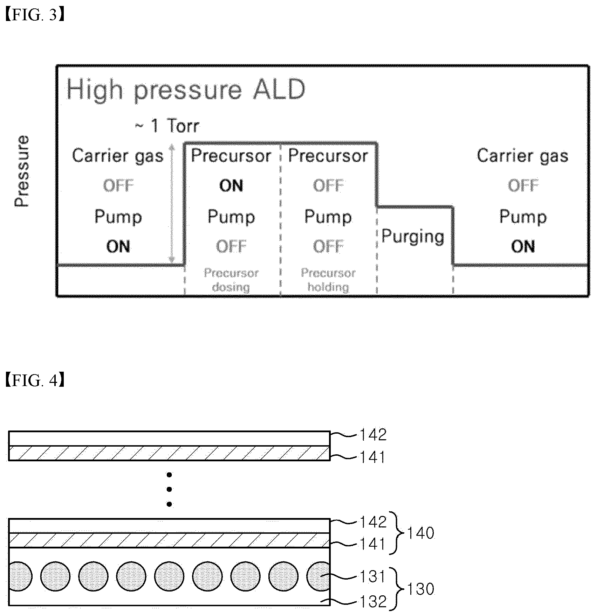

FIG. 3 is a schematic diagram illustrating a high-pressure atomic layer deposition method according to an embodiment of the present invention.

Referring to FIG. 3, the exhaust pump of the deposition equipment is activated to set a vacuum state in the chamber. Then, the exhaust pump is turned off and the precursor is introduced into the chamber. By introducing the precursor, the pressure in the chamber is set to a high pressure of more than 1 Torr. When the pressure in the chamber reaches the target value, the precursor is stopped and a holding time is given to induce the reaction. After the set holding time is over, the precursor is purged.

While the precursor supply is stopped and a holding time is given, a phase complexing channel layer is formed in the high-pressure environment. At the beginning of the reaction, an amorphous matrix is formed on the amorphous gate dielectric layer. Once the growth of the amorphous matrix has been sustained for some time, the formation of quantum dots on the amorphous matrix in the high-pressure environment is initiated. The quantum dots have a single crystal or polycrystalline phase. However, due to the relatively low processing temperature, the continuous growth of crystalline particle is not possible, and after the formation of roughly spherical quantum dots, the amorphous matrix is formed again.

The quantum dots are distributed in the amorphous matrix through the process described above.

FIG. 4 is a cross-sectional view illustrating the phase complexing channel layer and surface stabilization layer of FIG. 2, in accordance with a preferred embodiment of the present invention.

Referring to FIG. 4, a surface stabilization layer 140 is formed on the phase complexing channel layer 130.

The surface stabilization layer 140 has a repeating structure of an insulating layer 141 and an organic shielding layer 142. The insulating layer 141 and the organic shielding layer 142 form a kind of superlattice structure and act as a barrier of carrier, i.e., only carriers with energy above a threshold energy can be trapped at interface of phase complexing channel layer 130 and surface stabilization layer 140.

The quantized carriers are introduced into the phase complexing channel layer 130, and the introduced carriers can flow between quantum dots 131.

The insulating layer 141 of the surface stabilization layer 140 may have Al₂O₃, and Al-2,3-dimercapto-1-propanol (Al-DMP) may be used as the organic shielding layer 142. Due to the thiol group and Al of the organic shielding layer 142, the organic shielding layer 142 has a higher conductivity than the insulating layer 141, and external influence such as electromagnetic waves is interrupted.

The insulating layer 141 is formed first on the phase complexing channel layer 130. If the organic shielding layer 142 is formed first on the phase complexing channel layer 130, the organic shielding layer 142 will not be able to bond or chemically bond with the semiconductor material of the phase complexing channel layer 130, which is an inorganic material. Therefore, phase complexing channel layer 130 is not provided with a large bandgap material with a symmetrical structure, a rigid bond between the phase complexing channel layer 130 and the surface stabilization layer 140 will not be achieved, so that the desired properties will not be secured.

When the insulating layer 141 having an inorganic material is formed on the phase complexing channel layer 130 having an inorganic semiconductor or metal material, the oxygen atoms and the like of the insulating layer 141 can be chemically bonded with the elements comprising the phase complexing channel layer 130 to maintain strong properties.

Through the superlattice structure of the repeatedly formed inorganic insulating layer 141 and the organic shielding layer 142, the carriers introduced into the phase complexing channel layer 130 from the source electrode 150 can easily flow through the phase complexing channel layer 130 and form a signal in which noise is eliminated.

On the phase complexing channel layer 130, a source electrode 150 and a drain electrode 160 are formed. Preferably, the source electrode 150 and the drain electrode 160 are formed at positions opposite each other centered on the gate electrode 110. Further, the source electrode 150 and the drain electrode 160 may have Au, Pt, Ag, Ni, W, or Pd as metals.

### Manufacturing Example 1 : Fabrication of a phase complexing channel layer

ZnO is selected as the material for the phase complexing channel layer. The pressure of the chamber is kept at 1 Torr, DEZ (Diethylzinc) and H₂O are supplied as precursors, and the temperature of the chamber is kept at 100°C. The thickness of the phase complexing ZnO channel is controlled to determine the size of the ZnO quantum dots. The size of quantum dots in the phase complexing channel layer can be controlled by holding time of FIG. 3.

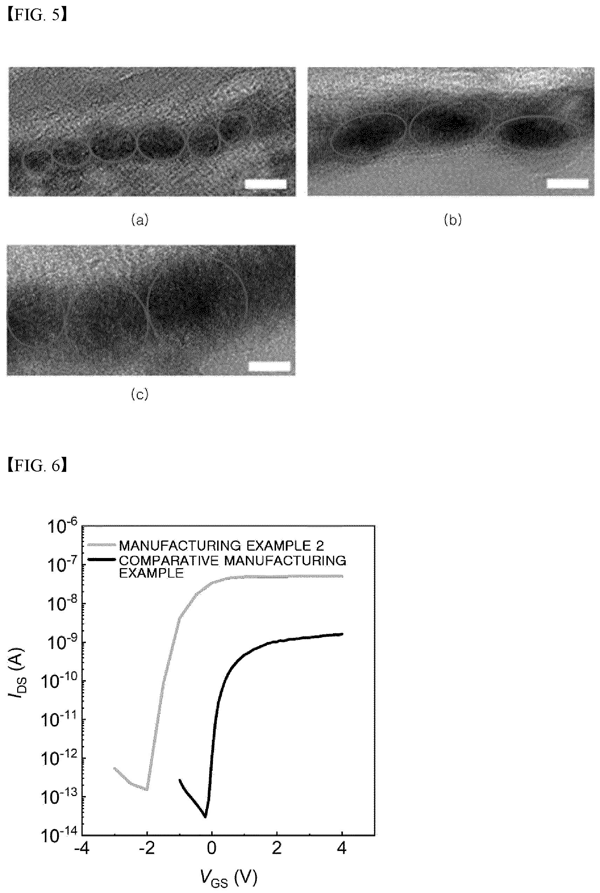

FIG. 5 is an image of quantum dots in a composite channel layer formed according to Manufacturing Example 1 of the present invention.

Referring to FIG. 5(a), phase complexing channel layer having thickness of 3.5 nm is formed and quantum dots of ZnO are formed within an amorphous matrix of ZnO. Furthermore, FIG. 5(b) shows quantum dots formed within a 5.3 nm thick phase complexing channel layer, and FIG. 5(c) shows quantum dots formed within a 7.7 nm thick ZnO phase complexing channel layer.

It can be seen that the size of the quantum dots increases as the thickness of the channel increases, and it is confirmed that the size of the quantum can be controlled.

### Manufacturing Example 2 : Fabrication of transistor having a phase complexing channel layer and surface stabilization layer

SiO₂ is used as the substrate, and Al having a thickness of about 60 nm is used as the gate electrode. Ti is used as a bonding layer for bonding the substrate and gate electrode, and the bonding layer is formed with a thickness of 10 nm. In addition, Al₂O₃ is formed as a gate dielectric layer on the gate electrode with a thickness of 11 nm. The Al₂O₃ is formed by using precursor TMA(Tri Methyl Aluminum). The phase complexing channel layer formed on the gate dielectric layer has the material of ZnO, and the phase complexing channel layer is formed with a thickness of 5.5 nm, and the average diameter of the ZnO quantum dots in the phase complexing channel layer is 3.5 nm. The separation distance between the ZnO quantum dots is less than 1 nm. In addition, Al₂O₃ is used as the insulating layer and Al-DMP is used as the organic shielding layer to form the surface stabilization layer. The thickness of the insulating layer is an average of 2 nm, the thickness of the organic shielding layer is also an average of 4 nm, and a repeating structure of the insulating layer/and organic shielding layer is formed, so that the total thickness of the surface stabilization layer is set to 10 nm. The source electrode and the drain electrode are made of the same material of Al.

### Comparative Manufacturing Example : Fabrication of transistor having phase complexing channel layer

A bonding layer, a gate electrode, a gate dielectric layer, and a phase complexing channel layer are formed on the substrate as Example 2. However, the formation of the surface stabilization layer is omitted, and a source electrode and a drain electrode are formed on the phase complexing channel layer as Example 2.

### Measurement Example: Measurement of low frequency noise characteristics

Noise characteristics are measured for the sample of Manufacturing Example 2 above and the sample of the Comparative Manufacturing Example. The source electrode is grounded, and the gate-source voltage Vgs is swept from -3V to 4V. Further, the drain-source voltage Vds is set to 2 V, and the drain-source current Ids is measured.

FIG. 6 is a graph of the electrical characteristics of two samples measured according to measurement example of the present invention.

Referring to FIG. 6, the x-axis represents Vgs and the y-axis represents Ids. Under the condition that a constant drain-source voltage Vds (=2V) is applied, the current Ids is measured as the voltage Vgs is increased.

In other words, FIG. 6 is data based on a common-source configuration of the transistor. In small-signal modeling, the source electrode is grounded, the small-signal voltage applied to the gate source acts as the input, and the small-signal current flowing between the drain and source acts as the output. If an output resistor is connected between the drain and source electrodes in a common-source configuration, a small-signal voltage is output between the drain and source electrodes.

The sample of the comparative manufacturing example has a sharp increase of Ids at Vgs over 0 V, and a sharp increase of Ids until Vgs reaches 1 V. The sample of the comparative manufacturing example has a phase complexing channel layer with the same composition and thickness as the sample of manufacturing example 2, and carriers migrate from the source electrode to the quantum dots in the phase complexing channel layer as Vgs is applied, and Ids increases relatively linearly due to Vds. Also, when Vgs above 1V is applied, the increase of Ids slows down, but Ids increases with the increase of Vgs.

**In** contrast, the sample of manufacturing example 2 shows a sharp increase in Ids in the region where Vgs is between -2 V and -1 V, which is attributed to the influence of the surface stabilization layer formed on the phase complexing channel layer. This is a very unusual phenomenon. Furthermore, when Vgs is over 0 V, Ids is saturated and little fluctuation of Ids is observed. The inventors of the present invention propose the following interpretation model for the above phenomenon.

### ① Doping effect and improvement of interfacial properties of phase complexing channel layer by surface stabilization layer

When Vgs is negative voltage, carriers do not enter the phase complexing channel layer. Since the phase complexing channel layer is composed of ZnO and has n-type conductivity, the carriers are electrons. Electrons cannot move through the phase complexing channel layer with a negative value of Vgs. However, looking at the graph in FIG. 6, Ids increases sharply in the range where Vgs is negative voltage. The oxygen in ZnO is reduced by TMA, which is a precursor used in the formation of Al2O3 as an inorganic insulating layer. That is, Al contained in the precursor combines with oxygen in ZnO and forms oxygen vacancies. This is a doping effect by Al, and the concentration of oxygen vacancies acting as donors increases, and the concentration of carriers increases. Therefore, carriers are activated by doping and positive Vds, resulting in an increase of Ids even at negative Vgs.

### ② Carrier influx into the phase complexing channel layer and ssaturation for Vgs

In general, in depletion n-MOS, Vds should be greater than Vgs for the transistor to enter the saturation region. More precisely, the requirement of Vds>Vgs-Vth (threshold voltage) should be satisfied. In FIG. 6, when Vgs is between 0 V and 1 V, Vds (=2 V) is greater than Vgs, so it satisfies the above condition and therefore operates in the saturation region. However, when Vgs increases above Vds from 2 V to 4 V, the transistor operates in the linear region. The linear region is the region where Ids increases linearly with increasing Vds.

In FIG. 6 above, Vgs is varied. As Vgs increases, Ids is characterized to increase due to the operation in the linear region, but the transistor of the present invention shows the phenomenon that Ids is fixed even as Vgs increases.

The above phenomenon is very unusual, and the inventor of the present invention interprets it as follows. First, the concentration of carriers tunneling between quantum dots through the amorphous matrix in the phase complexing channel layer is limited. Therefore, a certain amount of carriers is fed into the phase complexing channel layer through tunneling in the amorphous matrix to maintain saturation even when a high Vgs is applied. The carriers trapped in the phase complexing channel layer flow by Vds to form Ids through the quantum dots.

With the quantum dots in the amorphous matrix formed as a monolayer, the carriers trapped in the quantum dots are quantized in energy to tunnel through the amorphous matrix between the quantum dots, i.e., the number of carriers trapped in the quantum dots remains at a constant level even if the gate voltage is increased.

In other words, the low-noise transistor of the present invention is characterized in that when the state hybridization of quantum dots and amorphous matrix occurs, the drain current remains at a constant level even when the gate voltage is increased.

The behavior of the device of the present invention indicates that it acts as a current source with a fixed value of Ids in condition of over a certain Vgs. Verification of the graph of an idealized current source confirms that there is little variation in Ids and little resistance component due to carrier trapping at the interface with the gate dielectric.

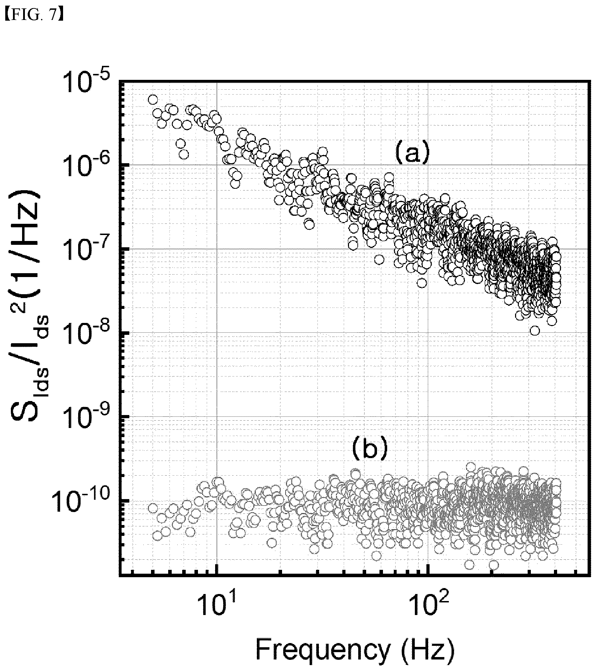

FIG. 7 is a graph of measuring noise according to measurement example of the present invention.

Referring to FIG. 7, the noise intensity of a sample of manufacturing example 2 and a sample of a comparative manufacturing example are measured, respectively. As described in FIG. 6, the devices have a common source configuration, i.e., the source electrode is grounded, the gate voltage Vgs is fixed at 3 V and Vds is fixed at 2 V as an input. Ids is measured and the noise component contained in Ids is analyzed.

In the graph of FIG. 7, S_{Ids} of the y-axis represents the current noise spectrum density of Ids, and S_{Ids} is expressed in A²/Hz. Since the current noise of the two manufacturing examples is measured at different current values, the noise spectrum density per unit current is compared by normalizing Ids², the square value of the measured current, to compare the noise spectrum density per unit current. Thus, the magnitude of the y-axis represents the noise spectrum density per unit current, normalized by the intensity or magnitude of the noise contained in the Ids, and has units of (1/Hz).

Further, graph (a) shows the noise magnitude of sample of the comparative manufacturing example and graph (b) shows the noise magnitude of sample of the manufacturing example 2. Finally, the y-axis shows the current noise spectrum density, which is a representation of the current variation over time as a frequency band. The sample of the comparative manufacturing example exhibits 1/f noise in the low frequency region, in which S_{Ids}/Ids² decreases by about 10 times when the frequency is increased by 10 times. However, the sample of manufacturing example 2 of the present invention does not observe 1/f noise even with an increase in frequency of the low frequency region, but only white noise with a constant S_{Ids}/Ids² value is showed. In FIG. 7, the frequency is supplied up to 400 Hz, and the sample of manufacturing example 2 exhibits an average value of noise spectrum density per unit current of 10⁻¹⁰ or less within the frequency range.

This is attributed to the introduction of a surface stabilization layer on phase complexing channel layer. Through the introduction of the surface stabilization layer, the phase complexing channel layer is located between the gate dielectric layer and the surface stabilization layer to have a quantum well structure. In particular, an inorganic insulating layer with a high bandgap is first formed on the phase complexing channel layer, and an organic shielding layer that blocks external disturbance is subsequently formed, so that the carriers in the phase complexing channel layer are not trapped at the interface, and a highly stable drain-source current can be formed.

In the present invention described above, a phase complexing channel layer and a surface stabilization layer are used. The surface stabilization layer is in direct contact with the phase complexing channel layer, and provides state stabilization and additional doping behavior of the phase complexing channel layer. In addition, the source electrode and drain electrode are directly contacted on the phase complexing channel layer. This allows carriers to be easily transported into the phase complexing channel layer.

In particular, carriers with a constant concentration in the phase complexing channel layer can operate in the saturation region because the trapping or detrapping phenomenon between the carriers and the gate dielectric layer is minimized by the surface stabilization layer, i.e., the drain current Ids can remain constant even if the gate voltage is increased.

On the other hand, if only a phase complexing channel layer is formed and surface stabilization layer is not introduced, the concentration of carriers in the phase complexing channel layer increases with the increase of the gate voltage. Therefore, Ids increases linearly with the increase of the gate voltage, even if Vds remains constant. This means that the transistor is in the linear region rather than the saturation region, and as shown in the transfer characteristic graph, fluctuations in the gate voltage appear as fluctuations in the drain current, and fluctuations in the voltage at the gate electrode appear as fluctuations in the drain current. In other words, low-frequency noise introduced into the gate electrode tends to be amplified at the output stage.

In addition, in the present invention, the carrier concentration of the phase complexing channel layer corresponding to the channel layer is limited to a saturated state, and the change in the number of carriers is limited. Therefore, flicker noise is essentially not generated by the surface stabilization layer. However, in the absence of the surface stabilizing layer, the carrier concentration increases with the application of the gate voltage, and the Ids increases with the increased carrier concentration. Furthermore, the carriers trapped or detrapped at the interface of the gate dielectric layer also increase due to the increased carrier concentration.

In the present invention, Ids remains constant as the gate voltage is increased in the common-source configuration, and the transistor exhibits virtually no substantial output resistance. This eliminates flicker noise.

## Claims

1. A low-noise transistor comprising:
a gate electrode formed on a substrate;
a gate dielectric layer formed on the gate electrode;
a phase complexing channel layer formed on the gate dielectric layer and having quantum dots formed within an amorphous matrix;
a surface stabilization layer formed on the phase complexing channel layer and removing flicker noise; and
a source electrode and a drain electrode formed on the composite channel layer,
wherein the surface stabilization layer is formed in direct contact with the phase complexing channel layer in a space between the source electrode and the drain electrode.

2. The low-noise transistor of claim 1, wherein the low-noise transistor has an average value of noise spectrum density per unit current of 10⁻¹⁰ or less at a frequency range of 400 Hz or less.

3. The low-noise transistor of claim 1, wherein spacing distance between the quantum dots and the gate dielectric layer is greater than spacing distance between the quantum dots.

4. The low-noise transistor of claim 1, wherein the quantum dots are distributed as a single layer within the amorphous matrix.

5. The low-noise transistor of claim 1, wherein the surface stabilization layer has a repeating structure of an inorganic insulating layer and an organic shielding layer, and the organic shielding layer has higher conductivity than the inorganic insulating layer.

6. The low-noise transistor of claim 5, wherein the inorganic insulating layer is formed on the phase complexing channel layer before the organic shielding layer, and is in direct contact with the amorphous matrix of the phase complexing channel layer.

7. The low-noise transistor of claim 6, wherein the inorganic insulating layer comprises Al₂O₃ and the organic shielding layer comprises Al-2,3-dimercapto-1-propanol (Al-DMP).

8. The low-noise transistor of claim 6, wherein the inorganic insulating layer dopes the phase complexing channel layer and increases Ids at negative Vgs.

9. The low-noise transistor of claim 1, wherein the low-noise transistor has common source configuration in which the gate electrode is used as an input and the drain electrode is used as an output.

10. A low-noise transistor comprising:
a phase complexing channel layer formed on a gate dielectric layer, in which quantum dots are formed as a single layer within an amorphous matrix; and
a surface stabilization layer in contact with the phase complexing channel layer and having a superlattice structure of an inorganic insulating layer and an organic shielding layer,
wherein the surface stabilization layer has a higher band gap than the phase complexing channel layer, the operation in the saturation region is performed even at Vgs having a value greater than Vds.

11. The low-noise transistor of claim 10, wherein the quantum dot and the amorphous matrix are made of the same material, and quantized carriers in the quantum dot move by tunneling through the amorphous matrix, which is an amorphous phase in a continuous state.

12. The low-noise transistor of claim 11. wherein the inorganic insulating layer of the surface stabilization layer is in contact with the amorphous matrix of the phase complexing channel layer.

13. The low-noise transistor of claim 10, wherein the low-noise transistor has an average value of noise spectrum density per unit current of 10⁻¹⁰ or less.

14. A low-noise transistor comprising a source electrode grounded at a small signal level; a drain electrode opposite the source electrode; and a gate electrode to which an input voltage of a small-signal level is applied, the low-noise transistor comprising:
a gate dielectric layer formed on the gate electrode;
a phase complexing channel layer formed on the gate dielectric layer; and
a surface stabilization layer formed on the phase complexing channel layer,
wherein the source electrode and the drain electrode are formed opposite to each other while directly contacting the phase complexing channel layer, and even if gate voltage increases, drain current flowing through the drain electrode to source electrode maintains a constant level by state hybridization of carriers.

15. The low-noise transistor of claim 14, wherein the phase complexing channel layer includes quantum dots formed within an amorphous matrix, and carriers moving through the phase complexing channel layer have energy quantized by the quantum dots, and number of carriers trapped at the quantum dots maintain a constant level even when the gate voltage increases.

16. The low-noise transistor of claim 15, wherein the quantum dots are formed in a single layer, and spacing distance between the quantum dots and the gate dielectric layer is greater than spacing distance between the quantum dots.

17. The low-noise transistor of claim 15, wherein the surface stabilization layer has a repeating structure of an inorganic insulating layer and an organic shielding layer, and the inorganic insulating layer is formed on the phase complexing channel layer and the phase complexing channel layer is doped with Al of the inorganic insulating layer to form Ids at negative Vgs.

18. The low-noise transistor of claim 17, wherein the low-noise transistor has an average value of noise spectrum density per unit current of 10⁻¹⁰ or less.

19. The low-noise transistor of claim 17, wherein the inorganic insulating layer comprises Al₂O₃ and the organic shielding layer comprises Al-2,3-dimercapto-1-propanol (Al-DMP).
